# FASCICULE DE BREVET EUROPEEN

(11) **EP 1 629 517 B1**
(45) Date de publication et mention de la délivrance du brevet: **03.01.2007**
(21) Numéro de dépôt: 04742679.6
(22) Date de dépôt: 07.05.2004
(51) Int. Cl.: H01J 37/32, C23C 16/54

(54) **DISPOSITIF DE TRAITEMENT DE SURFACE PAR ZONE D'UN ARTICLE PAR DÉCHARGE ÉLECTRIQUE À BARRIÈRE DIÉLECTRIQUE**
VORRICHTUNG ZUR BEREICHSWEISEN OBERFLÄCHENBEHANDLUNG EINES GEGENSTANDS MITTELS DIELEKTRISCH BEHINDERTER GASENTLADUNG
DEVICE FOR AREA-BASED SURFACE TREATMENT OF AN ARTICLE BY ELECTRIC DIELECTRIC BARRIER DISCHARGE

(30) Priorité: 21.05.2003 FR 0306084
(43) Date de publication de la demande: 01.03.2006
(73) Titulaire: L'Air Liquide Société Anonyme à Directoire et Conseil de Surveillance pour l'Etude et l'Exploitation des Procédés Georges Claude, 75321 Paris Cedex 07 (FR)
(72) Inventeur: VILLERMET, Alain, F-78220 Viroflay (FR); COEURET, François, F-78280 Guyancourt (FR); DELUMEAU, Jacques, F-95160 Montmorency (FR)
(74) Mandataire: Mellul-Bendelac, Sylvie Lisette
(86) Numéro de dépôt international: PCT/FR2004/001121
(87) Numéro de publication internationale: WO 2004/105079

(56) Documents cités:
- EP-A- 0 622 474
- US-A- 4 636 640
- US-A- 4 684 803
- US-A- 6 007 784

## Description

La présente invention concerne le domaine des traitements de surface par une décharge corona sous atmosphère gazeuse contrôlée (notamment des atmosphères à base d'azote comportant des ajouts contrôlés de silane, ou encore CO₂, N₂O, H₂..etc...).

Ce domaine a fait l'objet de nombreuses publications de la part de la Demanderesse, on pourra notamment se reporter aux documents suivants : EP-1 108 264, EP-622 474, WO 01/58 992 ou encore WO 02/40738.

Ces procédés et équipements permettent le traitement du substrat en défilement de manière homogène sur toute sa laize. Un tel traitement convient parfaitement à un grand nombre d'applications industrielles.

Toutefois, lorsque la surface d'un film est traitée par décharge corona, que ce soit dans l'air ou sous atmosphère gazeuse contrôlée, le scellage à chaud est rendu difficile.

Et l'on assiste donc au fait que les films destinés à être à la fois imprimés sur une partie et scellés sur une autre partie doivent combiner les caractéristiques a priori contradictoires d'une bonne impression (grâce au traitement corona) et d'une bonne « scellabilité » (film non traité). Il en va de même pour les films destinés à être à la fois contre-collés pour partie sur un substrat et scellés sur une autre partie.

Cette industrie s'est bien entendu penchée sur ce problème technique et on peut dire en résumé que deux solutions sont aujourd'hui proposées pour permettre de combiner ces deux caractéristiques techniques a priori contradictoires :
- soit la température du scellage est augmentée : cette solution permet en effet de sceller des films traités corona mais les conséquences engendrées au niveau de la chaîne de fabrication du produit final ne sont pas acceptables pour une production industrielle et ne sont d'ailleurs pas acceptées par bon nombre des transformateurs de films polymères.
- soit le traitement corona est appliqué sur les zones devant être imprimées ou contre-collées et n'est pas appliqué sur les zones devant être scellées : cette solution est aujourd'hui la solution retenue par quasiment l'ensemble de la profession, elle est effective grâce aux systèmes « traitement par zone » des stations corona sous air commercialement disponibles.

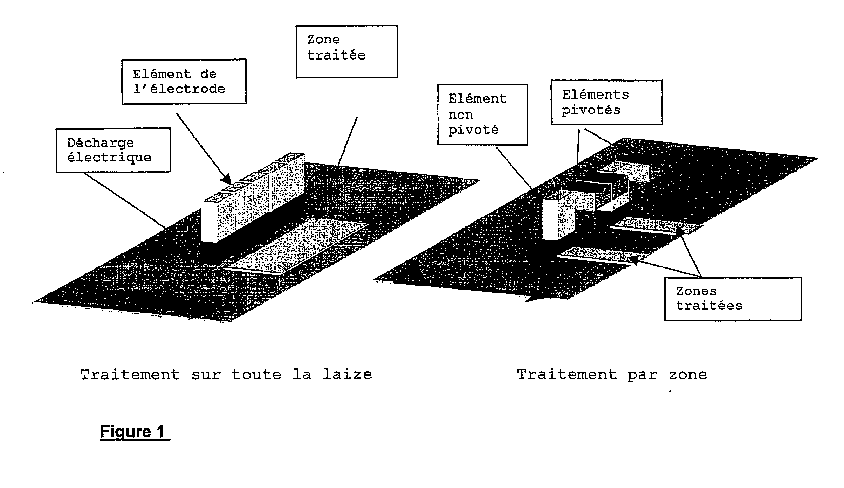

Les systèmes « traitement par zone » des stations corona sous air commercialement disponibles (on verra plus en détail leur schématisation ci-dessous en figure 1) consistent en une électrode métallique formée de petits éléments indépendants, pouvant pivoter selon un axe. Les éléments pivotés deviennent éloignés de la surface du film à traiter et ainsi, ces éléments bien que reliés à la haute tension ne permettent plus de créer une décharge sur la surface du film. En revanche, les éléments de l'électrode non pivotés permettent de créer une décharge sur la surface du film. De cette manière, le traitement corona est appliqué sous les éléments non pivotés et n'est pas appliqué sous les éléments pivotés (zonage). Les zones du film passant sous les éléments non pivotés sont donc imprimables (ou contre-collables), tandis que les zones du film passant sous les éléments pivotés sont scellables.

Pour illustrer cet état de la technique des procédés de traitement corona zonés on pourra se reporter notamment aux documents GB-2 014 799 et US-6 007 784.

Comme on vient de le voir le traitement corona sous air peut être aisément appliqué par zone, pour cela il suffit d'éviter la création de la décharge électrique sous certains éléments.

En revanche comme on va le voir maintenant, dans les applications où le traitement corona est réalisé sous atmosphère gazeuse contrôlée, l'électrode sert non seulement de support de haute tension pour l'application de la décharge électrique mais sert aussi d'injecteur du mélange gazeux de traitement. L'électrode étant par exemple creuse, pour permettre la circulation et l'injection dans la décharge du mélange gazeux, un traitement par zone réalisé selon le modèle d'éléments pivotants de la corona sous air de la Figure 1 entraînerait des difficultés d'étanchéité entre les éléments pivotés et les éléments non pivotés, d'alimentation en mélange gazeux de l'électrode ou encore de maintien de l'ensemble de l'électrode. Or, un traitement corona sous atmosphère gazeuse est efficace si le mélange gazeux est injecté au coeur même de la décharge avec un débit contrôlé. Il est donc impératif de garantir une bonne alimentation en mélange gazeux pour tous les éléments de l'électrode servant au traitement.

Une étanchéité mal contrôlée entre les éléments de l'électrode risque irrémédiablement de faire fuir le mélange gazeux aux jointures entre les éléments pivotés et les non pivotés. Le mélange gazeux n'étant alors injecté que partiellement voire pas du tout au coeur de la décharge, la qualité du traitement en deviendrait alors aléatoire.

Un traitement corona sous atmosphère gazeuse contrôlée par zone ne peut donc être réalisé correctement qu'à condition de permettre à la fois :
- la non-création de la décharge électrique sous certaines zones de l'électrode (comme pour les éléments pivotés des traitements corona sous air de l'art antérieur) ;
- la distribution, selon un débit contrôlé, du mélange gazeux à travers les zones de l'électrode servant au traitement.

Une solution possible pour respecter ces deux conditions serait de fabriquer une électrode composée d'éléments entièrement indépendants les uns des autres, chaque élément constituant une électrode complète permettant sa propre alimentation en haute tension et sa propre alimentation en mélange gazeux. Cette solution a l'avantage de garantir l'étanchéité entre les éléments car une électrode complète comporte non seulement ses propres alimentations mais également des parois assurant l'étanchéité et permettant la circulation de l'ensemble du mélange gazeux uniquement vers sa destination, à savoir le coeur de la décharge.

En revanche, elle est difficilement réalisable en pratique puisque les dimensions de chaque élément d'électrode sont de l'ordre de 1 cm, voire 5 mm. Pour les laizes typiquement utilisées dans l'industrie, à savoir de l'ordre de 1 à 2 mètres, il est difficilement concevable de fabriquer et d'assembler quelques centaines d'électrodes comportant chacune une connexion haute tension, une alimentation en mélange gazeux constituée elle-même de tubes et de raccords, le tout devant être étanche et mesurant moins de 1 cm de long . Cette solution apparaît donc irréalisable d'un point de vue pratique.

Une autre solution serait de séparer les deux fonctions de l'électrode, à savoir l'alimentation en haute tension et l'injection du mélange gazeux dans la décharge. Dans ce cas, il peut être envisagé d'utiliser une électrode de traitement corona sous air par zone avec des éléments pivotants alimentés uniquement en haute tension (comme dans l'exemple de la Figure 1) et de placer à proximité une buse d'injection du mélange gazeux. Cette solution a pour avantage de ne jamais présenter de risque de perte d'étanchéité entre les éléments de l'électrode puisque le mélange gazeux ne circule pas à l'intérieur de ceux-ci. Toutefois, la buse, séparée de l'électrode et placée à sa proximité, doit permettre l'injection du mélange gazeux au coeur de la décharge. Compte tenu des dimensions mises en oeuvre pour ce procédé, à savoir plus précisément une hauteur de la zone de décharge couramment de l'ordre de 1 mm, il est difficilement concevable d'assurer le bon débit du mélange gazeux au coeur de la décharge sans avoir recours à une augmentation du débit de ce même mélange gazeux au niveau de la buse. La différence entre le débit de la buse et celui alimentant la décharge correspond évidemment à la portion du mélange gazeux n'atteignant pas cet espace confiné de 1 mm de hauteur où se développe la décharge. Economiquement, cette portion de mélange gazeux « perdue » est difficilement acceptable par les clients de cette industrie car elle correspond à un coût supplémentaire puisque le débit devant être injecté au coeur de la décharge est imposé pour assurer une totale efficacité du traitement. Cette solution apparaît donc peu envisageable d'un point de vue économique.

On conçoit alors qu'il soit, pour cette industrie, intéressant et nécessaire de pouvoir proposer une nouvelle solution de traitement de surface par décharge corona en atmosphère gazeuse contrôlée, permettant un traitement par zones, dans des conditions acceptables tant techniquement qu'économiquement.

Pour ce faire, la présente invention propose un dispositif de traitement de surface par zone d'un article, par décharge électrique à barrière diélectrique, en présence d'un mélange gazeux de traitement, comprenant :
- une électrode métallique découpée en éléments individuels aptes chacun à être pivoté autour d'un axe central pour assurer une distance suffisante entre l'élément considéré pivoté et la zone de l'article en regard de l'élément considéré pour que la décharge ne puisse pas s'y développer; caractérisé en ce que
   - l'électrode métallique est creuse, permettant la circulation en son sein du mélange gazeux et l'acheminement de ce mélange jusqu'à la zone de décharge;
   - l'axe central de pivotement sert de canal de circulation du mélange gazeux au sein de l'électrode, et est muni d'orifices d'échappement du mélange gazeux vers la zone de décharge ;
   - le pivotement d'un des éléments de l'électrode réalise le bouchage de l'orifice d'échappement qui lui est associé, le mélange gazeux ne pouvant s'échapper que par les orifices d'échappement des éléments non pivotés.

Selon un des modes de réalisation de l'invention, chaque élément individuel comprend une chambre centrale d'homogénéisation individuelle, située en regard de son orifice d'échappement, l'ensemble des chambres centrales individuelles formant une chambre centrale d'homogénéisation sur toute la longueur de l'électrode, apte à être elle même alimentée en mélange gazeux au travers des dits orifices d'échappement, chaque chambre centrale d'homogénéisation individuelle étant munie d'une fente d'injection permettant l'injection de gaz sur l'article, et chaque élément individuel est muni d'une partie arrière apte, lorsque l'élément considéré est pivoté, à repousser la chambre centrale d'homogénéisation individuelle qui lui est associée pour se positionner entre les chambres centrales d'homogénéisation individuelles de ses éléments voisins non pivotés, et à venir ainsi procéder audit bouchage de l'orifice d'échappement de l'élément considéré dont on a fait pivoter la partie arrière.

Selon un des modes de réalisation de l'invention, l'axe central de pivotement réalise l'homogénéisation du flux gazeux par le fait qu'il est muni de composants de type chicane permettant de créer des turbulences dans le mélange gazeux.

La notion de « mélange gazeux de traitement » doit s'entendre selon l'invention comme signifiant un mélange gazeux contrôlé, donc non atmosphérique (par exemple une atmosphère à base d'azote comportant des ajouts contrôlés de silane, ou encore CO₂ , N₂O, H₂..etc...).

Comme il apparaîtra clairement à l'homme du métier, pour des raisons de clarté, il n'a pas été évoqué dans ce qui précède la présence d'une contre-électrode revêtue d'un matériaux diélectrique, contre-électrode bien entendu présente, l'article étant situé entre électrode et contre-électrode ou défilant carrément sur la contre-éléctrode. Pour les mêmes raisons elle ne figure pas sur les figures ci-après.

Comme on l'a vu ci-dessus, selon un des modes de réalisation de l'invention, chaque élément individuel est muni d'une partie arrière apte, lorsque l'élément considéré est pivoté, à repousser la chambre centrale d'homogénéisation individuelle qui lui est associée pour se positionner entre les chambres centrales d'homogénéisation individuelles de ses deux éléments voisins, et à venir ainsi procéder au bouchage de l'orifice d'échappement de l'élément considéré dont on a fait pivoter la partie arrière. On visualisera mieux ci-après à l'aide des figures les différentes situations envisageables où selon les éléments pivotés (éléments isolés ou plusieurs éléments consécutifs) une partie arrière donnée viendra se positionner entre deux chambres centrales immédiatement voisines ou bien plusieurs parties arrières consécutives vont être basculées et venir boucher l'espace situé entre les chambres centrales qui leur sont voisines et qui elles n'ont pas été déplacées.

D'autres caractéristiques et avantages ressortiront de la description suivante, donnée uniquement à titre d'exemple et faite en référence aux dessins annexés, sur lesquels :
- la figure 1 est une vue schématique d'une installation de traitement corona sous air par zone selon l'art antérieur.
- la figure 2 illustre de façon schématique la configuration d'un élément d'électrode conforme à l'invention, dans les deux dispositions envisagées i.e pivoté et non pivoté.
- la figure 3 permet de mieux visualiser le mode de réalisation de la figure 2 sur un ensemble de 6 éléments d'électrode.
- la figure 4 illustre un autre mode de réalisation de l'invention où l'axe de pivotement de l'électrode sert également de chambre centrale.

Comme évoqué plus haut, on reconnaît sur la figure 1 un système de « traitement par zone » par corona sous air, qui consiste en une électrode métallique formée de petits éléments indépendants juxtaposés, pouvant chacun pivoter selon un axe. Les éléments pivotés deviennent éloignés de la surface du film à traiter et ainsi, ces éléments bien que reliés à la haute tension ne permettent plus de créer une décharge sur la surface du film qui leur fait face. En revanche, les éléments de l'électrode non pivotés permettent de créer une décharge sur la surface du film qui leur fait face. De cette manière, le traitement corona est appliqué sous les éléments non pivotés et n'est pas appliqué sous les éléments pivotés (zonage). On voit bien ainsi la différence entre la configuration de gauche sur la figure où aucun élément d'électrode n'a été pivoté et donc le traitement est effectué sur toute la laize, et la configuration de droite où certains éléments de l'électrode ont été pivoté (i.e relevés et donc éloignés de la surface du film) et où donc seules certaines zones du film sont traitées (celles ayant en regard un élément d'électrode qui n'a pas été pivoté).

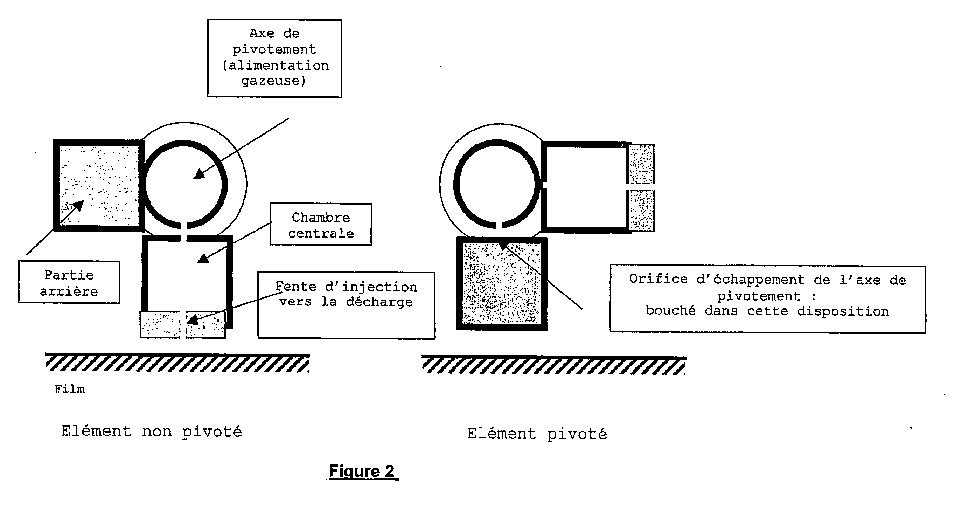

La figure 2 illustre quant à elle un mode de réalisation d'une électrode conforme à l'invention, découpée en éléments individuels (de longueur comprise typiquement entre 5 et 10 mm pour le mode représenté), comprenant un axe central de pivotement de l'ensemble des éléments qui tient lieu également d'alimentation générale en mélange gazeux et qui est pourvu d'orifices d'échappement sur toute sa longueur afin d'assurer une distribution la plus homogène possible du mélange gazeux sur toute la longueur de l'électrode. L'orifice d'échappement de l'axe central permet l'alimentation en mélange gazeux d'une chambre centrale, elle même munie d'une fente d'injection permettant l'injection de gaz sur le film en défilement.

Le maintien de l'étanchéité entre éléments voisins est obtenu selon l'invention par la présence d'une partie arrière (sorte d'épaule) à chaque élément. Ainsi lorsqu'un élément est pivoté, sa partie arrière vient exactement en regard des chambres centrales de ses voisins, se positionnant entre elles. Ainsi en position de pivotement, les orifices d'échappement de l'axe central (qui alimentent en gaz chaque chambre centrale) sont obstrués par l'épaule arrière lorsque l'élément correspondant est pivoté. De la sorte, le mélange gazeux n'alimente pas les éléments pivotés et ne peut s'échapper que par les fentes d'injection des éléments non pivotés.

Le mélange gazeux est ainsi utilisé, dans son ensemble et sans perte importante, pour alimenter la décharge, ce qui permet de maintenir le procédé économiquement acceptable par les industriels de la transformation de films polymères.

Un tel système permet de combiner :
- la simplicité de mise en oeuvre et de fabrication grâce à une alimentation, tant électrique que gazeuse, centralisée pour tous les éléments;
- avec une utilisation totale du mélange gazeux, n'entraînant ainsi pas de surcoût supplémentaire de fonctionnement.

Le fait que tous les éléments soient métalliques permet d'assurer l'alimentation en haute tension de chacun de ces éléments en alimentant seulement une extrémité de l'électrode, la transmission de la haute tension étant obtenue par contact entre éléments voisins.

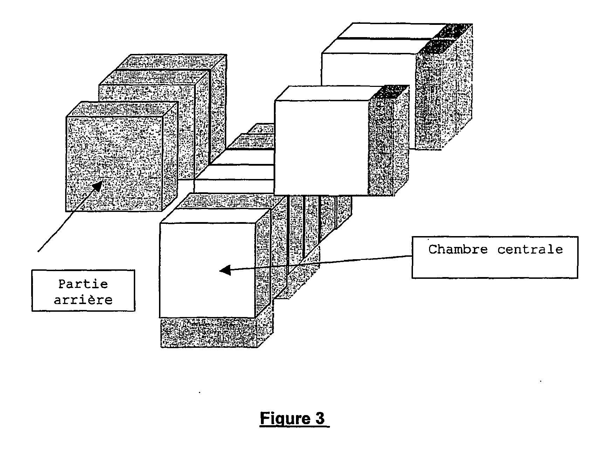

La figure 3 permet de mieux visualiser le mode de réalisation de la figure 2 sur un ensemble de 6 éléments d'électrode selon les deux dispositions pivotée et non pivotée : lorsqu'un élément est pivoté, son épaule arrière correspondante vient repousser la chambre centrale qui lui correspond et se positionner entre les deux chambres centrales qui forment ses voisines immédiates. On notera qu'à des fins de lisibilité de la figure, l'axe de pivotement de l'électrode n'est pas représenté.

Bien entendu on l'aura compris quand plusieurs parties arrières consécutives sont basculées, elles viennent boucher l'espace situé entre les chambres centrales qui leur sont voisines et qui elles n'ont pas été déplacées.

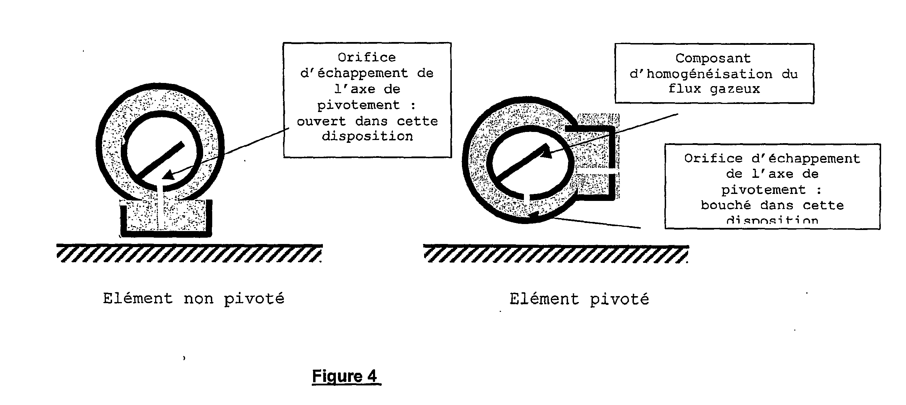

La figure 4 illustre pour sa part une variante de l'invention où la chambre centrale et l'axe central de pivotement sont confondus au sein d'une seule et même pièce. Dans cette configuration, l'homogénéisation du flux gazeux (réalisée par la chambre centrale dans la configuration longuement décrite ci-dessus) est réalisée ici par l'axe central de pivotement. Pour cela, ce dernier contient avantageusement des composants de type chicane afin de créer suffisamment de turbulences dans le flux gazeux pour réaliser une injection homogène tout au long de l'électrode.

En situation de pivotement l'élément est suffisamment éloigné du film pour ne pas créer de décharge électrique mais on réalise d'autre part le bouchage des orifices d'échappement de l'axe central de pivotement.

On l'a donc bien compris par la description qui précède, le non traitement de certaines zones est obtenu en évitant de développer une décharge en regard des éléments pivotés. Or, tous les éléments de l'électrode sont connectés à la haute tension, qu'ils soient pivotés ou non. Ainsi, tous les éléments sont susceptibles de créer une décharge à la surface du film. Compte tenu que la hauteur de décharge (distance entre les éléments non pivotés et la surface du film) dans les zones à traiter est de l'ordre de 1 mm, il convient d'assurer une distance entre les éléments pivotés et le film supérieure à 1 cm. Puisque la tension alimentant l'électrode est adaptée pour créer une décharge de hauteur 1 mm, cette distance de 1 cm est suffisamment élevée pour que la tension d'électrode reste inférieure à la tension de claquage de la décharge entre un élément pivoté et le film. De cette sorte, le traitement du film est assuré par les éléments non pivotés et le non traitement de certaines zones du film est assuré par pivotement des éléments correspondants.

Afin de pouvoir utiliser l'ensemble du mélange gazeux pour le traitement - à savoir son injection au coeur de la décharge - et d'éviter toute fuite importante qui serait synonyme de surcoût du procédé, une excellente étanchéité doit être assurée au niveau des chambres centrales de tous les éléments. Cette étanchéité doit être assurée dans les deux situations suivantes :
- L'étanchéité entre deux éléments voisins dans la même disposition (tous les deux sont pivotés ou tous les deux sont non pivotés) est assurée par contact serré entre les contours des chambres centrales des deux éléments. Ceci n'est réalisé qu'à condition que :
   1. le contact entre les deux éléments soit maintenu suffisamment serré .
   2. la rugosité des surfaces de contact est suffisamment faible pour permettre un contact, de type plan-plan, sur l'ensemble de ces deux surfaces en regard.
- L'étanchéité entre deux éléments voisins dans des dispositions différentes (l'un est pivoté et l'autre est non pivoté) est assurée par contact serré entre le contour de la chambre centrale de l'élément non pivoté et la partie arrière de l'élément pivoté. Ceci n'est réalisé qu'à condition que :
   1. le contact entre les deux éléments soit maintenu suffisamment serré.
   2. la partie arrière de l'élément pivoté vient en regard de la chambre centrale de l'élément voisin non pivoté.
   3. la rugosité des surfaces de contact est suffisamment faible pour permettre un contact, de type plan-plan, sur l'ensemble de ces deux surfaces en regard.

## Revendications

1. Dispositif de traitement de surface par zone d'un article, par décharge électrique à barrière diélectrique, en présence d'un mélange gazeux de traitement, comprenant:
- une électrode métallique découpée en éléments individuels aptes chacun à être pivoté autour d'un axe central pour assurer une distance suffisante entre l'élément considéré pivoté et la zone de l'article en regard de l'élément considéré pour que la décharge ne puisse pas s'y développer; **caractérisé en ce que**
- l'électrode métallique est creuse, permettant la circulation en son sein du mélange gazeux et l'acheminement de ce mélange jusqu'à la zone de décharge ;
- l'axe central de pivotement sert de canal de circulation du mélange gazeux au sein de l'électrode, et est muni d'orifices d'échappement du mélange gazeux vers la zone de décharge ;
- le pivotement d'un des éléments de l'électrode réalise le bouchage de l'orifice d'échappement qui lui est associé, le mélange gazeux ne pouvant s'échapper que par les orifices d'échappement des éléments individuels non pivotés.

2. Dispositif de traitement de surface par zone selon la revendication 1, **caractérisé en ce que** chaque élément individuel comprend une chambre centrale d'homogénéisation individuelle, située en regard de son orifice d'échappement, l'ensemble des chambres centrales individuelles formant une chambre centrale d'homogénéisation sur toute la longueur de l'électrode, apte à être elle même alimentée en mélange gazeux au travers des dits orifices d'échappement, chaque chambre centrale d'homogénéisation individuelle étant munie d'une fente d'injection permettant l'injection de gaz sur l'article, et **en ce que** chaque élément individuel est muni d'une partie arrière apte, lorsque l'élément considéré est pivoté, à repousser la chambre centrale d'homogénéisation individuelle qui lui est associée pour se positionner entre les chambres centrales d'homogénéisation individuelles de ses éléments voisins non pivotés, et à venir ainsi procéder audit bouchage de l'orifice d'échappement de l'élément considéré dont on a fait pivoter la partie arrière.

3. Dispositif de traitement de surface par zone selon la revendication 1, **caractérisé en ce que** l'axe central de pivotement réalise l'homogénéisation du flux gazeux par le fait qu'il est muni de composants de type chicane permettant de créer des turbulences dans le mélange gazeux.

## Claims

1. Device for the zonal surface treatment of an article, by dielectric barrier discharge, in the presence of a treatment gas mixture, comprising:
- a metal electrode divided into individual elements each capable of being swung about a central shaft in order to provide a sufficient distance between the swung-away element in question and that zone of the article opposite the element in question so that the discharge cannot extend therein; **characterized in that**
- the metal electrode is hollow so that the gas mixture can flow therein and so that this gas mixture can be conveyed right into the discharge zone;
- the central swing shaft serves as channel for the gas mixture to flow within the electrode, and is provided with outlet orifices for the gas mixture to enter the discharge zone; and
- when one of the electrode elements is swung away, the outlet orifice associated therewith is blocked, the gas mixture being able to escape only via the outlet orifices of the elements that are not swung away.

2. Zonal surface treatment device according to Claim 1, **characterized in that** each individual element includes an individual central homogenization chamber located opposite its outlet orifice, the set of individual central chambers forming a central homogenization chamber over the entire length of the electrode, which itself can be fed with the gas mixture via said outlet orifices, each individual central homogenization chamber being provided with an injection slot for injecting gas onto the article and each individual element is provided with a rear part capable, when the element in question is swung away, of pushing away the individual central homogenization chamber associated therewith so as to be positioned between the individual central homogenization chambers of its neighboring elements that have not been swung away, and thus of blocking, in said manner, the outlet orifice of the element in question, the rear part of which has been swung away.

3. Zonal surface treatment device according to Claim 1, **characterized in that** the central swing shaft homogenizes the gas flow as it is provided with baffle-type components for creating turbulence in the gas mixture.

## Patentansprüche

1. Vorrichtung zur Oberflächenbehandlung eines Artikels in Zonen durch elektrische Entladung mit dielektrischer Schranke im Beisein eines gasförmigen Behandlungsgemisches, umfassend:
- eine metallische Elektrode, die in Einzelelemente geschnitten ist, die jeweils um eine zentrale Achse geschwenkt werden können, um einen ausreichenden Abstand zwischen dem betreffenden geschwenkten Element- und der Zone des Artikels gegenüber dem betreffenden Element zu gewährleisten, damit die Entladung hier nicht stattfinden kann;
**dadurch gekennzeichnet, dass**
- die metallische Elektrode hohl ist und die Zirkulation des gasförmigen Gemisches in ihrem Inneren und die Beförderung dieses Gemisches zu der Entladungszone ermöglicht;
- die zentrale Schwenkachse als Zirkulationskanal für das gasförmige Gemisch innerhalb der Elektrode dient und mit Öffnungen für den Austritt des gasförmigen Gemisches zur Entladungszone versehen ist;
- das Schwenken eines der Elemente der Elektrode die Austrittsöffnung, die ihm zugeordnet ist, verschließt, wobei das gasförmige Gemisch nur durch die Austrittsöffnungen der nicht geschwenkten Einzelelemente austreten kann.

2. Vorrichtung zur Oberflächenbehandlung in Zonen nach Anspruch 1, **dadurch gekennzeichnet, dass** jedes Einzelelement eine individuelle zentrale Homogenisierungskammer umfasst, die gegenüber seiner Austrittsöffnung angeordnet ist, wobei die Gesamtheit der individuellen zentralen Kammern eine zentrale Homogenisierungskammer über die gesamte Länge der Elektrode bildet, die selbst mit gasförmigem Gemisch durch die Austrittsöffnungen versorgt werden kann, wobei jede individuelle zentrale Homogenisierungskammer mit einem Einspritzschlitz versehen ist, der das Einspritzen von Gas auf den Artikel ermöglicht, und dass jedes Einzelelement mit einem hinteren Teil versehen ist, der, wenn das betreffende Element geschwenkt wird, die ihm zugeordnete individuelle zentrale Homogenisierungskammer zurückschieben kann, um sich zwischen den individuellen zentralen Homogenisierungskammern seiner nicht geschwenkten Nachbarelemente anzuordnen und so ein Verschließen der Austrittsöffnung des betreffenden Elements, dessen hinterer Teil geschwenkt wurde, vorzunehmen.

3. Vorrichtung zur Oberflächenbehandlung in Zonen nach Anspruch 1, **dadurch gekennzeichnet, dass** die zentrale Schwenkachse die Homogenisierung des Gasflusses **dadurch** vornimmt, dass sie mit Komponenten vom Typ Ablenkblechen versehen ist, die es ermöglichen, Turbulenzen im gasförmigen Gemisch zu erzeugen.
